# EUROPÄISCHE PATENTSCHRIFT

(11) **EP 2 672 280 B1**
(45) Veröffentlichungstag und Bekanntmachung des Hinweises auf die Patenterteilung: **07.04.2021**
(21) Anmeldenummer: 13169655.1
(22) Anmeldetag: 29.05.2013
(51) Int. Cl.: G01R 27/18, H02H 1/00, G01R 27/16, G01R 31/12, G01R 31/52

(54) **Isolationsfehlerüberwachung mit Signalqualitätsanzeige**
Insulation fault monitoring with signal quality display
Surveillance des défauts d'isolation avec affichage de la qualité des signaux

(30) Priorität: 06.06.2012 DE 102012209586
(43) Veröffentlichungstag der Anmeldung: 11.12.2013
(73) Patentinhaber: Bender GmbH & Co. KG, 35305 Grünberg (DE)
(72) Erfinder: Schepp, Karl, 35447 Reiskirchen (DE); Groh, Tobias, 35325 Mücke (DE)
(74) Vertreter: advotec.

(56) Entgegenhaltungen:
- EP-A1- 0 654 673
- EP-A1- 1 593 983
- EP-A2- 1 909 368
- US-A1- 2009 256 576

## Beschreibung

Die Erfindung betrifft ein Verfahren zur Isolationsüberwachung in ungeerdeten elektrischen Gleich- oder Wechselstromnetzen, mit den Verfahrensschritten Einkopplung eines Messsignals zwischen aktiven Leitern des zu überwachenden Netzes und Erde und mit der Erfassung von Messsignal-Messwerten.

Weiterhin betrifft die Erfindung eine Vorrichtung zur Isolationsüberwachung in ungeerdeten elektrischen Gleich- oder Wechselstromnetzen, mit einer Ankopplungsschaltung zur Einkopplung eines Messsignals zwischen aktiven Leitern des zu überwachenden Netzes und Erde und zur Erfassung von Messsignal-Messwerten.

Um eine hohe Verfügbarkeit und Betriebssicherheit der elektrischen Stromversorgung sicherzustellen sowie die Personensicherheit im Bereich elektrischer Anlagen zu gewährleisten, kommen in zunehmendem Maße Stromversorgungsnetze zum Einsatz, deren aktive Teile von dem Erdpotential getrennt sind. Bei dieser als ungeerdetes IT-System (DIN VDE 0100-410):2007-06) bezeichneten Art des Stromversorgungsnetzes kann ein aktiver Leiter einen Isolationsfehler aufweisen, ohne dass der laufende Betrieb der Anlage unterbrochen werden muss, weil sich wegen des im Idealfall unendlich großen Impedanzwertes zwischen Leiter und Erde in diesem ersten Fehlerfall kein geschlossener Stromkreis ausbilden kann. Als Isolationsfehler wird dabei ein fehlerhafter Zustand des IT-Systems, insbesondere ein Körper- oder Erdschluss, also eine leitende Verbindung inaktiver Anlagenteile mit leitenden Betriebsmitteln oder eine leitende Verbindung eines aktiven Leiters gegen Erde, verstanden.

Aus dieser Betrachtung geht hervor, dass der Widerstand in dem zu überwachenden Netz, einschließlich der Widerstände aller daran angeschlossenen Betriebsmittel gegen Erde (Isolationswiderstand) ständig überwacht werden muss, da durch einen möglichen weiteren Fehler an einem anderen aktiven Leiter (zweiter Fehler) eine Fehlerschleife entstünde und der darin fließende Fehlerstrom in Verbindung mit einer Überstrom-Schutzeinrichtung eine Abschaltung der Anlage zur Folge hätte. Mit einer ständigen Isolationsüberwachung des ungeerdeten IT-Systems kann ein Absinken des Isolationswiderstands rechtzeitig erkannt und gemeldet werden. Die Anforderungen an derartige Isolationsüberwachungsgeräte sind in der internationalen Norm IEC 61557-8 festgeschrieben.

Dem Stand der Technik gemäß beruhen die Messverfahren zur Bestimmung des Isolationswiderstandes prinzipiell auf der Überlagerung einer in einem Isolationsüberwachungsgerät erzeugten Messspannung (Messsignal) zwischen den Leitern des IT-Netzes und Erde, so dass sich ein bestimmter, dem Isolationsfehler proportionaler Messstrom einstellt, der an einem Messwiderstand des Isolationsüberwachungsgerätes einen entsprechenden Spannungsabfall (erfasster Messsignal-Messwert) hervorruft. Überschreitet der Spannungsabfall infolge eines abgesunkenen Isolationswiderstands und damit eines höheren Messstroms einen bestimmten Wert, so wird eine Meldung ausgelöst. Um im Hinblick auf eine zuverlässige Isolationsüberwachung in heutigen modernen Netzen, in denen eine Vielzahl von Betriebsmitteln mit elektronischen Bauelementen versehen ist, Messverfälschungen entgegenzuwirken, hervorgerufen beispielsweise durch von Umrichtern erzeugte Gleichstromkomponenten, sind die Messverfahren stets weiter entwickelt worden. In reinen Wechselstromnetzen ohne verfälschende Gleichspannungsanteile kann das Verfahren der Überlagerung einer Messgleichspannung eingesetzt werden, wohingegen in störungsbehafteten Umgebungen eine gesteuerte, speziell getaktete Messspannung zum Treiben von Pulssignalen zur Anwendung gelangt.

So beschreibt die Veröffentlichung EP 0 654 673 A1 ein Verfahren zur Isolationsüberwachung in ungeerdeten Gleich- und Wechselstromnetzen, bei dem unter Vermeidung von Messwertverfälschungen kürzere Messzeiten dadurch erzielt werden, dass die Einzelimpulse der getakteten Messwechselspannung in ihrer Länge adaptiv an die Netzverhältnisse angepasst werden.

Die Druckschrift EP 1 586 910 B1 offenbart ein Verfahren und eine Vorrichtung zur Isolationsüberwachung mit einer gepulsten Messspannung, die durch eine DC-Offsetspannung überlagert wird, um mögliche vorhandene, die Messung verfälschende DC-Ströme im Netz zu kompensieren.

Die Patentschrift DE 101 06 200 C1 zeigt ein Verfahren und eine Einrichtung zur Isolationsüberwachung ungeerdeter elektrischer Netze, bei denen zur Vermeidung von Messfehlern der Messwert einer in Betrag und Dauer variablen Impulswechselspannung unter Berücksichtigung der Zeitkonstante des Netzes mit einem Messstrom-Kontrollwert in eingeschwungenem Zustand verglichen wird.

In den vorgenannten Veröffentlichungen wird zur Steuerung des Verfahrensablaufs und zur Durchführung der Berechnungen ein Mikroprozessor verwendet, wobei die Unterschreitung eines Ansprechwertes des Isolationswiderstands optisch und/oder akustisch gemeldet und der ermittelte Isolationswiderstandswert auf einem Anzeigegerät dargestellt wird. Wie z.B. in der Norm DIN VDE 0100-410 (VDE 0100-410) empfohlen, sollte "ein erster Fehler so schnell wie praktisch möglich beseitigt werden". Für den Anlagenbetreiber besteht daher das Verlangen, eine möglichst schnelle und klare Aussage über die Qualität des erfassten Messsignal-Messwertes bzw. der daraus abgeleiteten Größen zu erfahren.

Neben der Anzeige der (Absolut-)Werte für den ohmschen und kapazitiven Anteil des Isolationswiderstands erfolgt in der Druckschrift EP 1 586 910 A1 auch eine Darstellung von Informationen bezogen auf die Polarität der Messimpulse, so dass beispielsweise Fehler in bestimmten Zweigen erkannt werden können. Daneben sind optische und/oder akustische Alarmmeldungen für bestimmte Fehlersituationen vorgesehen. Als Anzeigemittel werden dabei neben einem Drehspulinstrument auch digitale Anzeigeformen vorgeschlagen.

In der US-Offenlegungsschrift US 2009/256576 A1 ist weiter eine Vorrichtung und ein Verfahren zur Erkennung und Lokalisierung von Erdschlussfehlern in ungeerdeten Stromversorgungssystemen beschrieben. Die Vorrichtung besteht im Wesentlichen aus einer Haupteinheit und einer mit einem Messstromwandler verbundenen, mobilen Lokalisierungseinrichtung. Das Verfahren beruht auf der Beeinflussung des Erdschlussfehlerstroms in seiner Frequenz und Amplitude, wobei durch zusätzliches Aufschalten einer Spannung der Fehlerstrom verstärkt und damit der Ort des Erdschlussfehlers genauer und schneller bestimmt werden kann. Die gemessenen Parameter werden mittels optischer Anzeigeeinheit als Information für den Benutzer bereitgestellt.

Durch dynamische Vorgänge in dem IT-System, wie beispielsweise niederfrequente Spannungen durch Frequenzumrichter oder Netzspannungsschwankungen bei PV Anlagen, ist es möglich, dass es trotz der an die Netzverhältnisse angepassten Messverfahren zu falschen Alarmmeldungen, verlängerten Messzeiten oder zum Ausfall der Isolationswiderstandsmessung kommt.

Besonders bei sogenannten Erdschlusswischern oder nur kurzeitig auftretenden Isolationsfehlern kann es für den Anlagenbetreiber schwierig sein, die Meldungen des Isolationsüberwachungsgerätes richtig zu interpretieren und die geeigneten Maßnahmen einzuleiten. Oft sind zusätzliche Messungen oder der Einsatz von Servicemitarbeiten notwendig, um den Zustand des IT -Systems richtig zu bewerten. Im schlimmsten Fall bleibt ein gestörtes Messsignal unentdeckt und das IT-System wird ohne Isolationsüberwachung betrieben.

Bislang führt ein erkanntes gestörtes Messsignal - einige Isolationsüberwachungsgeräte melden eine Messunterdrückung durch ein optisches Signal - in der Regel zu einer Unterbrechung der Isolationswiderstandsmessung. Nach einer unzuverlässigen Isolationsfehlermeldung wird oft manuell mit zusätzlichen Messgeräten der Zustand des IT-Systems überwacht, um nach einer bestimmten Überwachungszeit eine Aussage treffen zu können. Oft kommt es zu Serviceeinsätzen von Spezialisten, um den Isolationsfehler zu orten, obwohl die Ursache der fehlerhaften Alarmmeldung nur ein gestörtes Messsignal war.

Ausgehend von dem Stand der Technik wäre daher zusätzlich zu den Alarmmeldungen und der Anzeige der Messwerte eine Information wünschenswert, die die aktuelle Qualität des erfassten Messsignal-Messwertes in einer einfachen Form darstellt, um eine bessere Bewertung der Meldung des Isolationsüberwachungsgerätes zu ermöglichen. Weiterhin wäre eine trendanzeigende Darstellung über den fehlerhaften Leiter besonders in AC/DC oder DC Netzen sinnvoll.

Der vorliegenden Erfindung liegt somit die Aufgabe zu Grunde, ein Verfahren und eine Vorrichtung zur Isolationsüberwachung in ungeerdeten elektrischen Gleich- oder Wechselstromnetzen zu entwickeln, die eine schnelle und klare Beurteilung der Zuverlässigkeit des erfassten Messsignals (Messsignal-Messwert) erlauben.

Diese Aufgabe wird bezogen auf ein Verfahren dadurch gelöst, dass eine Signalqualität der erfassten Messsignal-Messwerte in Form eines Signal-Qualitätswertes ermittelt wird und eine Darstellung des Signal-Qualitätswertes erfolgt.

Zusätzlich zu den Alarmmeldungen und der Anzeige eines ermittelten Isolationswiderstandswertes erfolgt erfindungsgemäß die Ermittlung mindestens eines Signal-Qualitätswertes im Sinne einer Zuverlässigkeitsinformation, die eine Aussage über die Qualität des aktuell erfassten Messsignal-Messwertes erlaubt und damit dem Anwender eine Bewertung des Messergebnisses ermöglicht. Der so ermittelte Signal-Qualitätswert wird in einer für den Anwender wahrnehmbaren Darstellung wiedergeben, so dass dieser das aktuelle Messergebnis mit Hilfe der dargestellten Information hinsichtlich seiner Qualität beurteilen kann. Die bessere Einschätzung der Messsicherheit ermöglicht dem Anlagenbetreiber eine erfolgreichere und effizientere Isolationsfehlersuche und führt damit zu Kosteneinsparungen durch Vermeidung unnötiger Serviceeinsätze.

In vorteilhafter Weise basiert die Ermittlung des Signal-Qualitätswertes auf einer Auswertung des zeitlichen Verlaufs der erfassten Messsignal-Messwerte, wobei eine oder mehrere der folgenden Größen gewichtet verknüpft werden: statistische Kenngrößen des erfassten Messsignalverlaufs, Form des erfassten Messsignals, Ausreißer im erfassten Messsignalverlauf, Über-/Untersteuerungen, Gain-Detection, zeitliche Randbedingungen.

Um eine qualitative Aussage über das erfasste Messsignal machen zu können, wird der zeitliche Verlauf des erfassten Messsignals ausgewertet. Insbesondere werden statistische Kenngrößen wie Mittelwert und Varianz des Messwertes sowie Ausreißer und Über- oder Untersteuerungen analysiert und gewichtet zur Bestimmung des Signal-Qualitätswertes herangezogen. Darüber hinaus können eine Gain-Detection sowie zeitliche Randbedingungen wie eine Messzeitüberschreitung in die Bestimmung des Signal-Qualitätswertes einfließen, um eine noch sicherere Bewertung der Qualität des erfassten Messsignals zu erreichen.

In weiterer Ausgestaltung werden mit Vorteil ein oder mehrere der weiteren folgenden Parameter gewichtet in die Ermittlung der Messsignal-Signalqualität einbezogen: Isolationswiderstandswert, Wert der Ableitkapazität, Netzspannung, Netzfrequenz.

Der Isolationswiderstandswert und der Wert der Ableitkapazität sowie weitere Netzparameter und Messwerte wie Netzspannung, Netzfrequenz werden in die Berechnung des Signal-Qualitätswertes miteinbezogen. Mit der Einbeziehung dieser weiteren Größen kann die Aussagekraft über die Signalqualität weiter gesteigert werden. Auch erlaubt die Berücksichtigung der weiteren Netzparameter und Messwerte eine Optimierung der (Einstell-)Parameter des Isolationsüberwachungsgerätes sowie eine Auswahl von geeigneten Messverfahren, gegebenenfalls in Verbindung mit der Wahl eines besser geeigneten Isolationsüberwachungsgerätes.

Bevorzugt werden Alarmwerte zusammen mit dazugehörigen Angaben der Signalqualität des Messsignals gespeichert. In einem derartigen Historienspeicher können ältere Messwerte, insbesondere ältere Alarmmeldungen, mit ihren korrespondierenden Signal-Qualitätswerten aufgezeichnet werden, um daraus Schlussfolgerungen für eine klarere Bewertung künftiger Ereignisse ziehen zu können. Diese Berücksichtigung bekannter Korrelationen kann im Sinne einer Lernkurve auch automatisiert erfolgen.

Vorteilhafterweise erfolgt die Darstellung der Signalqualität des Messsignals optisch wahrnehmbar als Balkenanzeige und/oder als Prozentangabe in Zahlen und/oder als verschiedenfarbige LED-Anzeige. Um den Anwender schnell und klar über die Signalqualität zu informieren, wird der aktuelle Signal-Qualitätswert durch eine Balkenanzeige dargestellt, die beispielsweise in der Art einer Signalstärkeanzeige bei Mobilfunkgeräten mehrstufig als Säulendiagramm ausgeführt sein kann oder bei der die Balkenlänge einem bestimmten Signal-Qualitätswert entspricht.

Neben einer optischen Darstellungsmöglichkeit kann die Darstellung der Signalqualität des Messsignals auch akustisch wahrnehmbar erfolgen. Qualitativ unzuverlässige Messwerte können durch einen in Lautstärke und Frequenz variierbaren Ton signalisiert werden.

Weiterhin ist für den Signal-Qualitätswert ein Schwellwert einstellbar, bei dessen Unterschreitung eine optisch und/oder akustisch wahrnehmbare Meldung erfolgt und/oder ein Schaltausgang aktiviert wird. Der Anwender kann manuell festlegen, dass bei Unterschreitung eines bestimmten Signal-Qualitätswertes eine Meldung erfolgen soll und somit auf den aktuellen Netzzustand aufmerksam machen. Neben einer optischen und/oder akustischen Warnmeldung wird bei der Unterschreitung ein Schaltausgang aktiviert, über den ein Signal an weitere elektrische Betriebsmittel zu deren Ansteuerung ausgegeben werden kann.

In einer bevorzugten Ausführung der Erfindung wird der fehlerhafte aktive Leiter bestimmt und dargestellt. Im Fehlerfall bei Unterschreiten eines bestimmten Isolationswiderstandswerts erhält der Anwender somit auch eine Information darüber, in welchem der aktiven Leiter eines IT-Systems der Isolationsfehler wahrscheinlich aufgetreten ist. Dabei erfolgt die Darstellung des fehlerhaften aktiven Leiters vorzugsweise optisch wahrnehmbar als Balkenanzeige oder Säulendiagramm mit Trendangabe und/oder als Prozentangabe in Zahlen mit Trendangabe in Richtung auf den mit größerer Wahrscheinlichkeit fehlerbehafteten aktiven Leiter.

Das Messsignal wird vorzugsweise als eine gepulste Messwechselspannung eingekoppelt um Messverfälschungen entgegenzuwirken. Insbesondere kann durch derartige, an die Netzverhältnisse angepasste Messimpulse beispielsweise den durch von Umrichtern erzeugten Gleichstromkomponenten begegnet werden.

Die der Erfindung zu Grunde liegende Aufgabe wird bezogen auf eine Vorrichtung in Verbindung mit dem Oberbegriff des Anspruchs 11 weiterhin gelöst durch eine Recheneinheit zur Ermittlung eines Signal-Qualitätswertes des Messsignal-Messwertes und eine Darstellungseinrichtung zur Darstellung des ermittelten Signal-Qualitätswertes.

Korrespondierend zu den Verfahrensmerkmalen des erfindungsgemäßen Verfahrens weist die Vorrichtung zur Isolationsüberwachung eine Recheneinheit auf, die die Berechnungen, insbesondere die Gewichtung und die geeignete Verknüpfung der Eingangssignale, zur Ermittlung des Signal-Qualitätswertes durchführt. Die Recheneinheit ist als Mikroprozessor ausgeführt, auf dem in einem Programmcode die Eingangssignale digital verarbeitet werden und als Ergebnis ein Signal-Qualitätswert ausgegeben wird. Der so ermittelte Signal-Qualitätswert wird erfindungsgemäß dem Anwender über eine Schnittstelle unmittelbar und in verständlicher Darstellung nahebracht.

In weiterer Ausgestaltung weist die Vorrichtung Erfassungseinrichtungen zur Erfassung weiterer netzkennzeichnender elektrischer Parameter auf. Diese Parameter wie beispielsweise der Wert der Ableitkapazität, die Netzspannung oder die Netzfrequenz werden in der Recheneinheit zur Ermittlung der Signalqualität herangezogen, um eine möglichst genaue Aussage über die Qualität und die Zuverlässigkeit des erfassten Messsignal-Messwertes zu treffen.

Weiterhin weist die Vorrichtung einen Datenspeicher zur Aufzeichnung der Alarmwerte zusammen mit dazugehörigen Angaben der Signalqualität des Messsignals auf. Auf diesen Datenspeicher kann zurückgegriffen werden, um durch die Verknüpfung von Alarmwert und zu diesem Alarmwert gehörenden Netzzuständen zuverlässigere Aussagen und Bewertungen für künftige Ereignisse zu treffen.

Vorzugsweise ist die Darstellungseinrichtung zur Darstellung der Signalqualität des Messsignals optisch in Form einer Balkenanzeige und/oder als Prozentangabe in Zahlen und/oder als verschiedenfarbige LED-Anzeige ausgeführt. Diese Darstellungsform erlaubt eine für den Anwender schnelle und klare Wahrnehmung der aktuellen Signalqualität des Messsignals. Zusätzlich kann die Darstellungseinrichtung zur Darstellung der Signalqualität des Messsignals akustisch in Form einer tongebenden Einrichtung ausgeführt sein, um den Anwender auf kritische Netzsituationen aufmerksam zu machen.

Weiterhin kann die Vorrichtung eine Einstelleinrichtung zur Einstellung eines Schwellwertes für den Signal-Qualitätswert umfassen. Die Einstelleinrichtung ermöglicht, dass eine Unterschreitung des durch den Anwender vorgegebenen Schwellwertes eine optische und/oder akustische Meldung auslöst und somit ein kritischer Netzzustand deutlich signalisiert wird. Die optische Signalisierung kann beispielsweise durch separate Anzeigemittel oder eine blinkende Anzeige der zur Darstellung der Signalqualität dienenden Darstellungseinrichtungen erfolgen. Akustisch kann eine Unterschreitung durch einen Warnton mitgeteilt werden.

Weiterhin kann die Vorrichtung einen Schaltausgang aufweisen, der bei Unterschreitung des Schwellwertes für den Signal-Qualitätswert aktiviert wird. Neben einer optisch und/oder akustisch wahrnehmbaren Darstellung der Unterschreitung des Schwellwertes kann somit ein Schaltausgang zur Ansteuerung weiterer angeschlossener elektrischer Betriebsmittel durch die Einstelleinrichtung zur Einstellung eines Schwellwertes für den Signal-Qualitätswert aktiviert werden.

In einer bevorzugten weiteren Ausführungsform weist die Vorrichtung weitere Darstellungseinrichtungen zur Anzeige des in einem DC- oder in einem AC/DC-Netz fehlerhaften aktiven Leiters auf. Aus dieser Darstellung, die auch als Trendanzeige ausgeführt sein kann, ist für den Anwender im Fehlerfall erkennbar, welcher aktive Leiter mit größerer Wahrscheinlichkeit fehlerbehaftet ist.

Die Vorrichtung umfasst vorteilhafterweise eine Generatorschaltung zur Erzeugung einer gepulsten Messwechselspannung als Messsignal. Diese Generatorschaltung ermöglicht es, an das IT-Netz angepasste Messimpulse zu erzeugen, um möglichen Messwertverfälschungen durch überlagerte Gleichströme entgegenzuwirken.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
**Fig. 1****:** ein funktionales Blockdiagramm des erfindungsgemäßen Verfahrens,
**Fig. 2****:** eine detaillierte Darstellung der Signalqualität als Säulendiagramm mit Prozentangabe und
**Fig. 3****:** eine Trendanzeige zur Bestimmung des fehlerhaften Leiters.

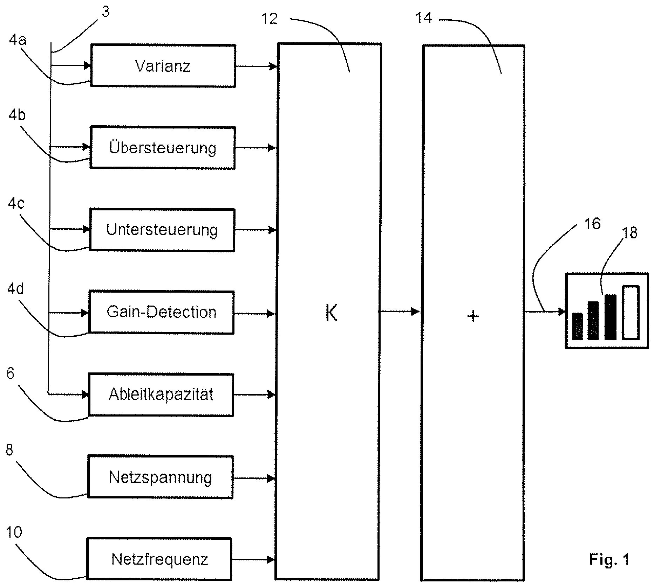

**Fig.1** zeigt ein funktionales Blockdiagramm des erfindungsgemäßen Verfahrens 2 zur Ermittlung der Signalqualität bei einer Isolationsüberwachung. Dargestellt ist die prinzipielle Wirkungsweise mit beispielhaft ausgewählten Daten als Eingangssignale.

Die aus dem zeitlichen Verlauf der erfassten Messsignal-Messwerte 3 gewonnenen Größen Varianz 4a, Über-/Untersteuerung 4b/4c und Gain-Detection 4d, die aus dem erfassten Messsignal-Messwert 3 berechnete Ableitkapazität 6 sowie die weiteren unabhängig von dem Messsignal-Messwert 3 erfassten Netzkenngrößen Netzspannung 8 und Netzfrequenz 10 werden als in digitaler Form bereitgestellte Eingangsdaten vorzugsweise in einer als Mikroprozessor ausgestalteten Recheneinheit individuell gewichtet 12 und in geeigneter Weise miteinander verknüpft 14. Als Ergebnis der digitalen Signalverarbeitung 12, 14 wird ein Signal-Qualitätswert 16 ermittelt und optisch in Form eines Säulendiagramms 18 dargestellt. Somit ist für den Benutzer während der Isolationswiderstandsmessung unmittelbar erkennbar, wie zuverlässig die auf den aktuell erfassten Messsignal-Messwerten 3 basierenden Auswertungen, insbesondere der ermittelte Isolationswiderstandswert, sind.

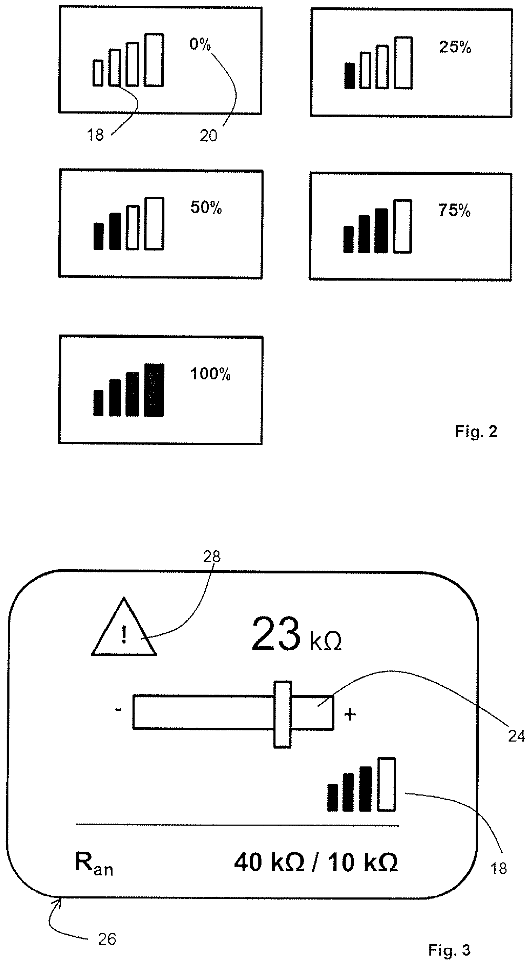

In **Fig. 2** ist eine detaillierte Darstellung der Signalqualität in Form eines 4-stufigen Säulendiagramms 18 bei verschiedenen Signalqualitätsstufen zu sehen. Zusätzlich ist der entsprechende Signal-Qualitätswert 16 als Prozentangabe 20 eingeblendet, wobei eine Anzeige von vier ausgefüllten Säulen einer vollen Signalqualität (100 %) des erfassten Messsignals 3 entspricht.

**Fig. 3** zeigt eine Trendanzeige 24 als grafische Darstellung zur Bestimmung eines fehlerhaften aktiven Leiters in einem AC/DC- oder DC-IT-Netz. Die Trendanzeige 24 ist Bestandteil eines Displays 26, das daneben noch eine Darstellung des Signal-Qualitätswerts 16 als Säulendiagramm 18 sowie weitere Zahlenangaben als Informationen über den Isolationswiderstandswert und ein Warnsymbol 28 umfasst. Dem vorliegenden Beispiel ist zu entnehmen, dass, angezeigt durch das Warnsymbol 28, ein Isolationsfehler aufgetreten ist, der mit größerer Wahrscheinlichkeit in dem +-Leiter des IT-Systems zu suchen ist, da die Trendanzeige 24 in Richtung des positiven Leiters tendiert. Die Zuverlässigkeit der Messung, also die Qualität der Messsignal-Messdaten 3, ist entsprechend den drei ausgefüllten Säulen des Säulendiagramms 18 mit einem Signal-Qualitätswert von 75 % zu beurteilen.

## Patentansprüche

1. Verfahren zur Isolationsüberwachung in ungeerdeten elektrischen Gleich- oder Wechselstromnetzen mit den Verfahrensschritten
- Einkopplung eines Messsignals zwischen aktiven Leitern des zu überwachenden Netzes und Erde und
- Erfassung von Messsignal-Messwerten (3),
**dadurch gekennzeichnet, dass**
- eine Signalqualität der erfassten Messsignal-Messwerte (3) in Form eines Signal-Qualitätswertes (16) ermittelt wird und
- eine Darstellung (18, 20) des Signal-Qualitätswertes (16) erfolgt.

2. Verfahren nach Anspruch 1,
**dadurch gekennzeichnet,**
**dass** die Ermittlung des Signal-Qualitätswertes (16) auf einer Auswertung des zeitlichen Verlaufs der erfassten Messsignal-Messwerte (3) basiert, wobei eine oder mehrere der folgenden Größen (4a, 4b, 4c, 4d) gewichtet verknüpft (12, 14) werden: statistische Kenngrößen des erfassten Messsignalverlaufs (4a), Form des erfassten Messsignals, Ausreißer im erfassten Messsignalverlauf, Über-/Untersteuerungen (4b, 4c), Gain-Detection (4d), zeitliche Randbedingungen.

3. Verfahren nach Anspruch 1 oder 2,
**dadurch gekennzeichnet,**
**dass** in die Ermittlung der Messsignal-Signalqualität ein oder mehrere der weiteren folgenden Parameter gewichtet einbezogen (12, 14) werden: Isolationswiderstandswert, Wert der Ableitkapazität (6), Netzspannung (8), Netzfrequenz (10).

4. Verfahren nach einem der Ansprüche 1 bis 3,
**dadurch gekennzeichnet,**
**dass** Alarmwerte zusammen mit dazugehörigen Angaben der Signalqualität des Messsignals gespeichert werden.

5. Verfahren nach einem der Ansprüche 1 bis 4,
**dadurch gekennzeichnet,**
**dass** die Darstellung der Signalqualität des Messsignals optisch wahrnehmbar als Balkenanzeige (18) und/oder als Prozentangabe in Zahlen (20) und/oder als verschiedenfarbige LED-Anzeige erfolgt.

6. Verfahren nach einem der Ansprüche 1 bis 5,
**dadurch gekennzeichnet,**
**dass** die Darstellung der Signalqualität des Messsignals akustisch wahrnehmbar erfolgt.

7. Verfahren nach einem der Ansprüche 1 bis 6,
**dadurch gekennzeichnet,**
**dass** für den Signal-Qualitätswert (16) ein Schwellwert einstellbar ist, bei dessen Unterschreitung eine optisch und/oder akustisch wahrnehmbare Meldung erfolgt und/oder ein Schaltausgang aktiviert wird.

8. Verfahren nach einem der Ansprüche 1 bis 7,
**dadurch gekennzeichnet,**
**dass** der fehlerhafte aktive Leiter bestimmt und dargestellt wird.

9. Verfahren nach Anspruch 8,
**dadurch gekennzeichnet,**
**dass** die Darstellung des fehlerhaften aktiven Leiters optisch wahrnehmbar als Balkenanzeige oder Säulendiagramm mit Trendangabe (24) und/oder als Prozentangabe in Zahlen mit Trendangabe erfolgt.

10. Verfahren nach einem der Ansprüche 1 bis 9,
**dadurch gekennzeichnet,**
**dass** als Messsignal eine gepulste Messwechselspannung eingekoppelt wird.

11. Vorrichtung zur Isolationsüberwachung in ungeerdeten elektrischen Gleich- oder Wechselstromnetzen, mit einer Ankopplungsschaltung zur Einkopplung eines Messsignals zwischen aktiven Leitern des zu überwachenden Netzes und Erde und zur Erfassung von Messsignal-Messwerten (3),
**gekennzeichnet durch**
eine Recheneinheit eingerichtet zur Ermittlung eines Signal-Qualitätswertes (16) des Messsignal-Messwertes und eine Darstellungseinrichtung eingerichtet zur Darstellung des ermittelten Signal-Qualitätswertes.

12. Vorrichtung nach Anspruch 11,
**gekennzeichnet durch**
Erfassungseinrichtungen zur Erfassung weiterer netzkennzeichnender elektrischer Parameter.

13. Vorrichtung nach Anspruch 11 oder 12,
**gekennzeichnet durch**
einen Datenspeicher zur Aufzeichnung der Alarmwerte zusammen mit dazugehörigen Angaben der Signalqualität des Messsignals.

14. Vorrichtung nach einem der Ansprüche 11 bis 13,
**dadurch gekennzeichnet,**
**dass** die Darstellungseinrichtung zur Darstellung der Signalqualität des Messsignals optisch in Form einer Balkenanzeige (18) und/oder als Prozentangabe in Zahlen (20) und/oder als verschiedenfarbige LED-Anzeige ausgeführt ist.

15. Vorrichtung nach einem der Ansprüche 11 bis 14,
**dadurch gekennzeichnet,**
**dass** die Darstellungseinrichtung zur Darstellung der Signalqualität des Messsignals akustisch in Form einer tongebenden Einrichtung ausgeführt ist.

16. Vorrichtung nach einem der Ansprüche 11 bis 15,
**gekennzeichnet durch**
eine Einstelleinrichtung zur Einstellung eines Schwellwertes für den Signal-Qualitätswert (16).

17. Vorrichtung nach Anspruch 16,
**gekennzeichnet durch**
einen Schaltausgang, der bei Unterschreitung des Schwellwertes für den Signal-Qualitätswert (16) aktiviert wird.

18. Vorrichtung nach einem der Ansprüche 11 bis 17,
**gekennzeichnet durch**
weitere Darstellungseinrichtungen (24) zur Wiedergabe des in einem DC- oder in einem AC/DC-Netz der fehlerhaften aktiven Leiters.

19. Vorrichtung nach einem der Ansprüche 11 bis 18,
**gekennzeichnet durch**
eine Generatorschaltung zur Erzeugung einer gepulsten Messwechselspannung als Messsignal.

## Claims

1. A method for insulation monitoring in unearthed electric direct or alternating current networks, comprising the method steps:
- coupling in a measuring signal between active conductors of the network to be monitored and earth, and
- registering measured values (3) of the measuring signal,
**characterized in that**
- a signal quality of the registered measured values (3) of the measuring signal is determined in the form of a signal quality value (16), and
- that a display (18, 20) of the signal quality value (16) is effected.

2. The method according to claim 1,
**characterized in that**
the determination of the signal quality value (16) is based on an evaluation of the temporal curve of the registered measured values (3) of the measuring signal, one or more of the following parameters (4a, 4b, 4c, 4d) being weightedly combined (12, 14): statistical parameters of the registered measuring signal curve (4a), the form of the registered measuring signal, outliers in the registered measuring signal curve, under/over-modulations (4b, 4c), gain detection (4d), temporal marginal conditions.

3. The method according to claim 1 or 2,
**characterized in that**
one or more of the following further parameters are weightedly included (12, 14) in the determination of the signal quality of the measuring signal: insulation resistance value, value of the leakage capacity (6), supply voltage (8), supply frequency (10).

4. The method according to any of the claims 1 to 3,
**characterized in that**
alert values are saved together with the associated information on the signal quality of the measuring signal.

5. The method according to any of the claims 1 to 4,
**characterized in that**
the display of the signal quality of the measuring signal is effected in an optically perceivable manner as a bar display (18) and/or as a percentage in figures (20) and/or as a multicolored LED display.

6. The method according to any of the claims 1 to 5,
**characterized in that**
the display of the signal quality of the measuring signal is effected in an acoustically perceivable manner.

7. The method according to any of the claims 1 to 6,
**characterized in that**
for the signal quality value (16), a threshold value is adjusted, upon whose undercutting an optically and/or acoustically perceivable report is effected and/or a switching output is activated.

8. The method according to any of the claims 1 to 7,
**characterized in that**
the faulty active conductor is determined and displayed.

9. The method according to claim 8,
**characterized in that**
the display of the faulty active conductor is effected in an optically perceivable manner as a bar display or a column diagram with a trend indication (24) and/or as a percentage in figures with a trend indication.

10. The method according to any of the claims 1 to 9,
**characterized in that**
a pulsed alternating measuring voltage is coupled in as a measuring signal.

11. A device for insulation monitoring in unearthed electric direct or alternating current networks, comprising a coupling circuit for coupling in a measuring signal between active conductors of the network to be monitored and earth and for registering measured values (3) of the measuring signal,
**characterized by**
a computing unit configured for determining a signal quality value (16) of the measured value of the measuring signal and a displaying means configured for displaying the determined signal quality value.

12. The device according to claim 11,
**characterized by**
registering means for registering further electrical parameters characterizing the network.

13. The device according to claim 11 or 12,
**characterized by**
a data memory for recording the alert values together with associated information on the signal quality of the measuring signal.

14. The device according to any of the claims 11 to 13,
**characterized in that**
the displaying means for displaying the signal quality of the measuring signal is realized optically in the form of a bar display (18) and/or as a percentage in figures (20) and/or as a multicolored LED display.

15. The device according to any of the claims 11 to 14,
**characterized in that**
the displaying means for displaying the signal quality of the measuring signal is realized acoustically in the form of a sound-generating means.

16. The device according to any of the claims 11 to 15,
**characterized by**
an adjusting device for adjusting a threshold value for the signal quality value (16).

17. The device according to claim 16,
**characterized by**
a switching output, which is activated upon undercut of the threshold value for the signal quality value (16).

18. The device according to any of the claims 11 to 17,
**characterized by**
further displaying means (24) for the rendition of the faulty active conductor in a DC or AC/DC network.

19. The device according to any of the claims 11 to 18,
**characterized by**
a generator circuit for generating a pulsed alternating measuring voltage as a measuring signal.

## Revendications

1. Procédé pour la surveillance d'isolement dans des réseaux électriques non-mis à la terre à courant continu ou alternatif, le procédé comprenant des étapes suivantes :
- coupler un signal de mesure entre des conducteurs actifs du ré seau à être surveillé et la terre, et
- enregistrer des valeurs mesurées (3) du signal de mesure,
**caractérisé en ce**
- **qu'**une qualité de signal des valeurs mesurées enregistrées (3) du signal de mesure est déterminée sous forme d'une valeur de qualité de signal (16), et
- en ce qu'une présentation (18, 20) de la valeur de qualité de signal (16) est effectuée.

2. Procédé selon la revendication 1,
**caractérisé en ce que**
la détermination de la valeur de qualité de signal (16) est fondée sur une évaluation d'une courbe temporale des valeurs mesurées enregistrées (3) du signal de mesure, un ou plusieurs des paramètres suivants (4a, 4b, 4c, 4d) étant combinés de manière pondérée (12, 14): paramètres statistiques de la courbe de signal de mesure enregistrée (4a), la forme du signal de mesure enregistré, des valeurs aberrantes dans la courbe de signal de mesure enregistrée, sousmodulations/surmodulations (4b, 4c), détection de gain (4d), des conditions marginales temporales.

3. Procédé selon la revendication 1 ou 2,
**caractérisé en ce**
**qu'**un ou plusieurs des autres paramètres suivants sont inclus de manière pondérée (12, 14) dans la détermination de la qualité du signal de mesure: valeur de résistance d'isolement, valeur de la capacité de fuite (6), tension d'alimentation (8), fréquence industrielle (10).

4. Procédé selon l'une quelconque des revendications 1 à 3,
**caractérisé en ce que**
des valeurs d'avertissement sont stockées ensemble avec les informations associées sur la qualité du signal de mesure.

5. Procédé selon l'une quelconque des revendications 1 à 4,
**caractérisé en ce que**
la présentation de la qualité du signal de mesure est effectuée dans une manière perceptible optiquement comme diagramme à barres (18) et/ou comme pourcentage en chiffres (20) et/ou comme écran LED multicolore.

6. Procédé selon l'une quelconque des revendications 1 à 5,
**caractérisé en ce que**
la présentation de la qualité de signal du signal de mesure est effectuée dans une manière perceptible optiquement.

7. Procédé selon l'une quelconque des revendications 1 à 6,
**caractérisé en ce**
**qu'**une valeur de seuil est ajustée pour la valeur de qualité de signal (16), un avis perceptible optiquement et/ou acoustiquement étant effectué et/ou une sortie de commutation étant activée quand la valeur de seuil n'étant pas atteinte.

8. Procédé selon l'une quelconque des revendications 1 à 7,
**caractérisé en ce que**
le conducteur actif erroné est déterminé et présenté.

9. Procédé selon la revendication 8,
**caractérisé en ce que**
la présentation du conducteur actif erroné est effectuée dans une manière perceptible optiquement comme diagramme à barres ou comme diagramme à bâtons ayant chacun un indicateur de trend (24) et/ou comme pourcentage en chiffres ayant un indicateur de trend.

10. Procédé selon l'une quelconque des revendications 1 à 9,
**caractérisé en ce**
**qu'**une tension de mesure alternative pulsée est couplée comme signal de mesure.

11. Dispositif pour la surveillance d'isolement dans des réseaux électriques non-mis à la terre à courant direct ou alternatif, le dispositif comprenant un circuit de couplage pour coupler un signal de mesure entre des conducteurs actifs du réseau à être surveillé et la terre et pour enregistrer des valeurs mesurées (3) du signal de mesure,
**caractérisé par**
une unité de computation configurée pour la détermination d'une valeur de qualité de signal (16) de la valeur mesurée du signal de mesure et par un dispositif de présentation configuré pour présenter la valeur de qualité de signal déterminée.

12. Dispositif selon la revendication 11,
**caractérisé par**
des dispositifs d'enregistrement pour enregistrer des autres paramètres électriques caractérisant le réseau.

13. Dispositif selon la revendication 11 ou 12,
**caractérisé par**
une mémoire de données pour enregistrer les valeurs d'avertissement ensemble avec des informations associées sur la qualité du signal de mesure.

14. Dispositif selon l'une quelconque des revendications 11 à 13,
**caractérisé en ce que**
le dispositif de présentation pour présenter la qualité du signal de mesure est réalisé optiquement sous le forme d'un diagramme a barres (18) et/ou comme pourcentage en chiffres (20) et/ou comme écran LED multicolore.

15. Dispositif selon l'une quelconque des revendications 11 à 14,
**caractérisé en ce que**
le dispositif de présentation pour présenter la qualité du signal de mesure est réalisé acoustiquement sous le forme d'un dispositif générant de sons.

16. Dispositif selon l'une quelconque des revendications 11 à 15,
**caractérisé par**
un dispositif d'ajustement pour ajuster une valeur de seuil pour la valeur de qualité de signal (16).

17. Dispositif selon la revendication 16,
**caractérisé par**
une sortie de commutation qui est activé quand la valeur de seuil n'est pas atteinte pour la valeur de qualité de signal (16).

18. Dispositif selon l'une quelconque des revendications 11 à 17,
**caractérisé par**
des autres dispositifs de présentation (24) pour rendre le conducteur actif erroné dans un réseau CC ou CA/CC.

19. Dispositif selon l'une quelconque des revendications 11 à 18,
**caractérisé par**
un circuit de générateur pour générer une tension de mesure alternative pulsée comme signal de mesure.
